# EUROPEAN PATENT SPECIFICATION

(11) **EP 3 643 470 B1**
(45) Date of publication and mention of the grant of the patent: **09.06.2021**
(21) Application number: 19204910.4
(22) Date of filing: 23.10.2019
(51) Int. Cl.: B29B 9/16, H01J 37/32, C08J 3/28

(54) **APPARATUS FOR PLASMA TREATMENT OF GRANULAR POLYMER MATERIAL**
VORRICHTUNG ZUR PLASMABEHANDLUNG VON KÖRNIGEM POLYMERMATERIAL
DISPOSITIF DE TRAITEMENT AU PLASMA DE MATÉRIAU POLYMÈRE GRANULAIRE

(30) Priority: 26.10.2018 IT 201800009838
(43) Date of publication of application: 29.04.2020
(73) Proprietor: Bonetto S.r.l., 10064 Pinerolo (TO) (IT)
(72) Inventor: SOLA, Claudio, 10064 Pinerolo (TO) (IT)
(74) Representative: De Bonis, Paolo

(56) References cited:
- EP-A2- 0 993 922
- CN-U- 202 205 700
- DE-A1-102011 107 431
- DE-C1- 19 612 270
- US-A- 5 316 739
- US-A1- 2008 145 553
- US-A1- 2012 145 041

## Description

### TEXT OF THE DESCRIPTION

### Field of the invention

The present invention relates to plasma treatment of polymer materials, in particular with the aim of enhancing the characteristics of surface adhesion of the polymer material. The invention has been developed with particular reference to the technical field of forming of isothermic containers for foodstuff products, but it is understood that it can be applied to multiple sectors that make use of polymer materials.

### Prior art

Prior art documents in this field include, i.a., US 2008/0145553 A1.

The production of isothermic containers for transporting fresh and/or frozen foodstuff products currently envisages the use of rotational-moulding techniques combined with foaming techniques. In greater detail, by means of rotational moulding of polyethylene in granular form the outer double-wall casing of the isothermic container is obtained, meaning thereby a hollow semifinished product having the final outer and inner dimensions of the container, but having a space in the wall without material.

Basically, it is a semifinished product that has the outer and inner walls of the isothermic container separated by a gap. In a subsequent processing step, the gap is filled with polyurethane foam by means of a traditional injection-foaming process.

A typical drawback that afflicts isothermic containers thus produced is the separation between the polyethylene walls and the core of polyurethane foam during normal use. The difference of thermal expansion, impact, and continuous thermal cycles to which the container is subjected cause a surface detachment of
the two materials. This is due to the poor wettability and modest properties of surface adhesion of polyethylene. The effect is immediately visible on isothermic containers, since they exhibit evident swellings of the polyethylene walls following upon interruption of the interface with the polyurethane insulator. Such swellings are disastrous from the operative standpoint since, in addition to the possibility of triggering failure, they render impracticable storage of containers in an orderly arrangement and/or with optimal occupation of space. The swollen walls prevent in fact strict juxtaposition of the containers, and moreover limit the possibility of stacking thereof.

The currently most widespread measures to overcome this drawback are basically of two types:
i) provision of polyethylene bridges for joining together the outer wall and the inner wall of the casing of the container; this is a measure that exclusively contains the effects of interruption of the interface, since it does not intervene on the causes thereof; the aim of this measure is exclusively that of limiting swelling of the polyethylene walls and maintaining the shape of the container as close as possible to the nominal shape, so as to have as little impact as possible on the possibility of handling and storing the containers during use; moreover, the polyethylene bridges provide in practice thermal bridges within the insulator layer, which markedly worsen the performance; and
ii) application of a layer of adhesive within the polyethylene walls prior to foaming in such a way as to reinforce the interface between the polyethylene walls and the polyurethane core by means of the adhesive itself; this is a measure that counters the causes of separation, but proves markedly disadvantageous from an economic standpoint since it requires highly skilled labour force and long times for application of the adhesive.

### Object of the invention

The object of the invention is to solve the technical problems described above. In particular, the object of the invention is to improve the properties of surface adhesion of polyethylene to reinforce the interface between the latter and further materials.

### Summary of the invention

The object of the present invention is achieved by a machine according to claim 1, a related method according to claim 10; further preferred embodiments are claimed in the dependent claims.

### Brief description of the drawings

The invention will now be described with reference to the annexed drawings, in which:
- Figure 1 is a perspective view of a machine according to the invention;
- Figures 2 to 4 are views of a treatment cell of the machine according to the invention;
- Figure 5 is a cross-sectional view according to the trace V-V of Figure 2;
- Figure 6 consists of four parts, A, B, C, D, which illustrate various views of an electrode of the reaction cell of Figures 2 to 4; and
- Figures 7 to 10 illustrate an operating sequence of the machine according to the invention.

### Detailed description

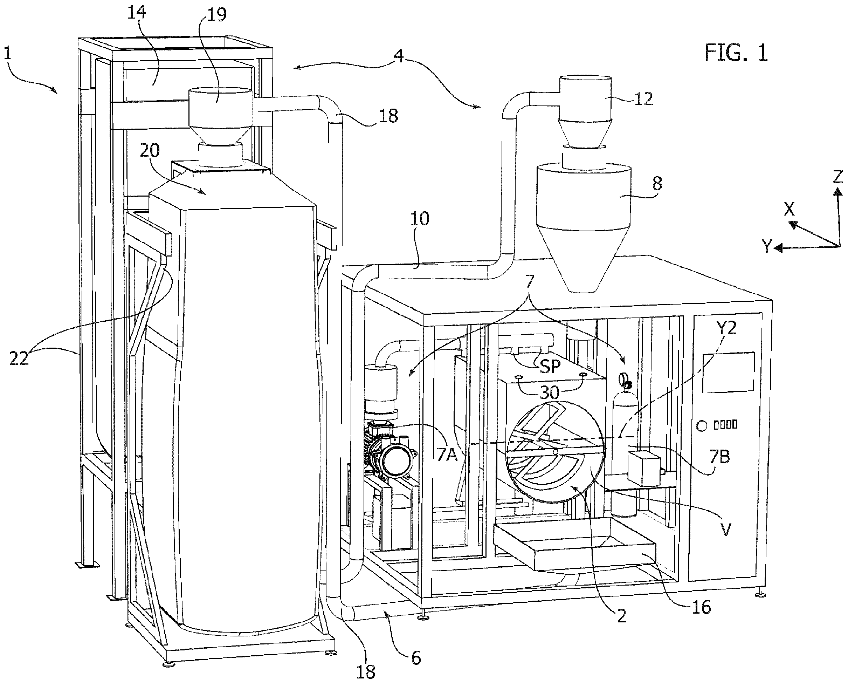

The reference number 1 in Figure 1 designates as a whole a machine for plasma treatment of a polymer material in granular form, in particular polyethylene. The machine 1 comprises a treatment cell 2, which delimits a treatment volume V for a granular polymer material, a dispenser unit 4 for supply of a pre-set amount of granular polymer material to the treatment cell 2, an evacuation unit 6 for emptying the treatment cell of the material, and a fluid-dispensing unit.

The fluid-dispensing unit comprises a negative-pressure source in fluid communication with the treatment volume V and configured for setting up vacuum conditions within the volume V. The term "vacuum conditions" is intended to indicate conditions of subatmospheric pressure that may not necessarily correspond to the condition of theoretical vacuum, but comprise a wider range of degrees of vacuum that can be achieved operatively (for example, by means of vacuum pumps commonly available in the industrial sector).

In this embodiment, the negative-pressure source comprises a battery of vacuum pumps 7A (alternatively, it is possible to provide a single pump with higher performance).

In this regard, the negative-pressure source may advantageously comprise a first vacuum pump (purely by way of example a pump of the type Leybold Trivac 65 with oil Fomblin - Ø KF50 -), a second vacuum pump (for example, a pump of the type Leybold Roots Ruvac WAU 251 - Ø ISO-K100), and a dust filter with microfilter for protection of the first and second vacuum pumps (Ø ISO-K100) .

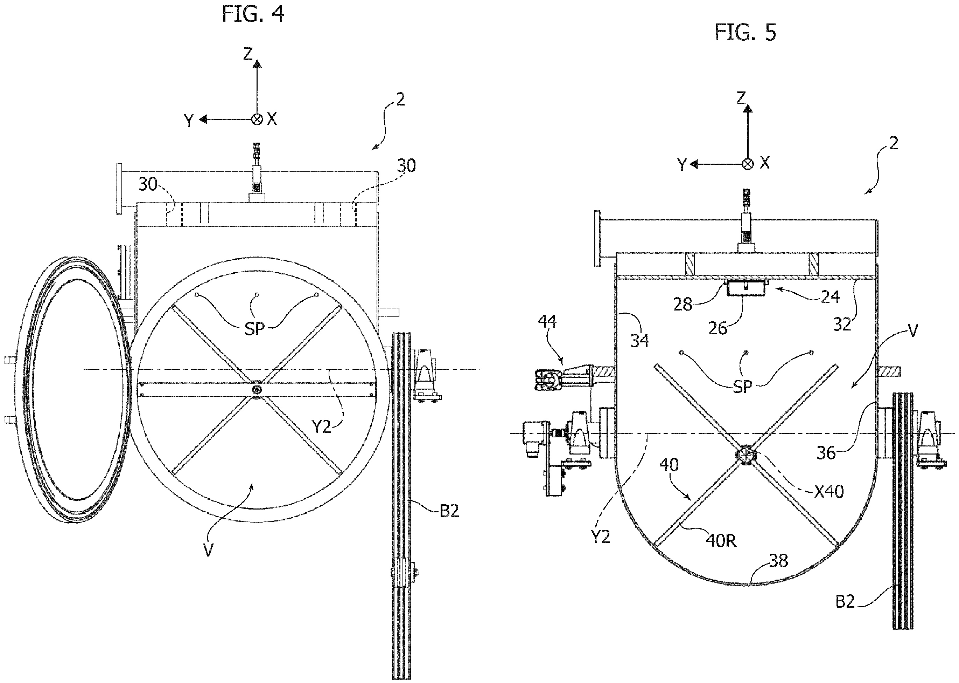

Connection to the treatment volume is preferably obtained by means of a flexible hose that is connected to one or more suction ports SP (Figures 4 and 5). The treatment volume V is moreover equipped with a vacuum sensor (Ø KF16) for monitoring the conditions of negative pressure inside the volume itself.

The flow in the fluidic connection between the negative-pressure source and the treatment volume V is regulated by means of a main valve of an electropneumatic type (Ø ISO-K100), whereas restoring of the atmospheric pressure in the treatment volume V is obtained via an electromechanical air-admittance vent valve (Ø KF25).

The fluid-dispensing unit further comprises a gas-supply unit 7B configured for introducing one or more treatment gases for the granular polymer material into the treatment volume V. In the embodiment illustrated herein, the gas-supply unit 7B comprises a cylinder of pressurized treatment gas.

The dispenser unit 4 includes a loading hopper 8 set above said treatment cell 2, which is supplied - through a duct 10 - via a feeder 12 that draws raw granular polymer material from a storage container 14.

The evacuation unit 6 comprises a collection tank 16 located at the foot of the treatment cell 2 and an evacuation duct 18, installed in which is a feeder 19 configured for moving the treated polymer material from the collection tank 16 to a storage bag 20, supported by a frame 22.

The loading hopper 8 and the storage bag 20 may conveniently be provided with level sensors for detecting the level of granular polymer material in order to determine the levels of maximum filling and minimum filling/total emptying.

The sensors in question may moreover be conveniently connected to the fluid-dispensing unit, and in particular to the negative-pressure source 7A, in such a way as to subordinate the action of the negative-pressure source - hence, setting-up of the vacuum in the treatment volume V - to the presence of the granular polymer material.

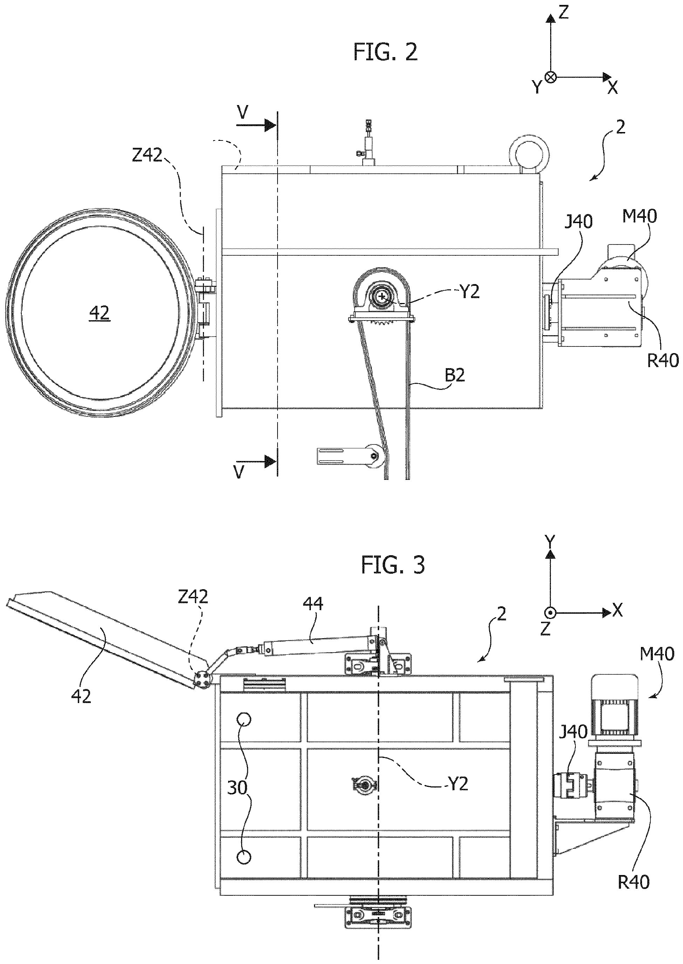

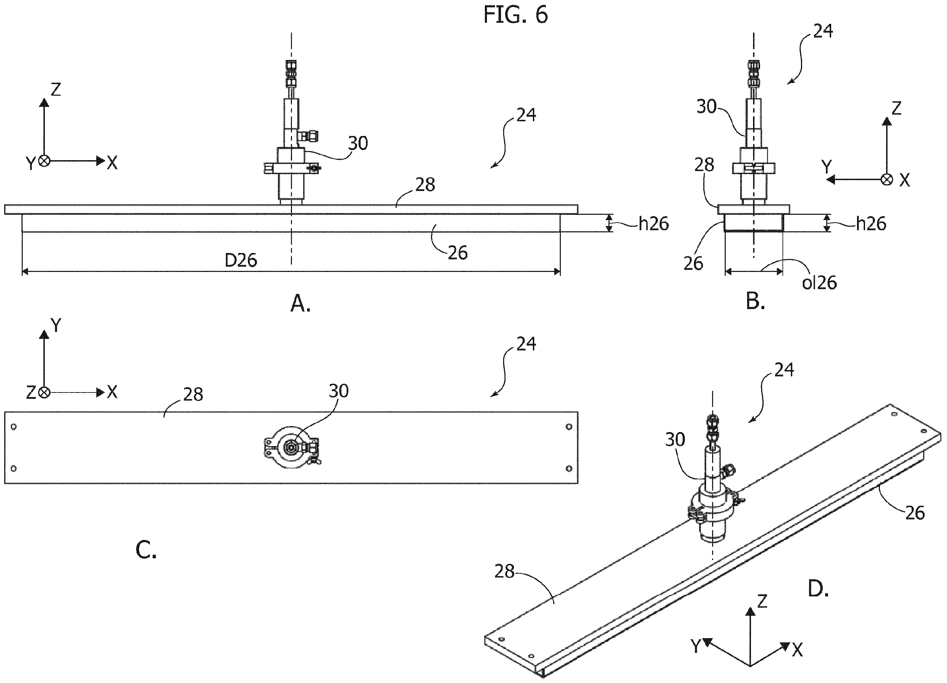

With reference to Figures 2-5 and 6A-6B, set within the treatment cell 2, and in particular within the treatment volume V, is a plasma-generation unit 24 including an electrode 26 for generation of the plasma. The electrode 26 has an elongated shape with a first dimension D26 oriented in a main direction of development X and a second dimension d26 oriented in a secondary direction of development Y, where the ratio between the first dimension D26 and the second dimension d26 is comprised between 20:1 and 15:1, preferably between 16:1 and 18:1. The electrode 26 moreover has a further secondary direction of development Z orthogonal to the main direction of development X and to the secondary direction of development Y. The electrode 26 has a third dimension h26 oriented in the further secondary direction of development, and the ratio between the first dimension D26 and the third dimension h26 is comprised between 30:1 and 27:1.

The electrode 26 is carried by a supporting plate 28, which is used for connection of the unit 24 to the walls of the treatment volume V and as current collector for ignition of the plasma. For this purpose, the plate 28 is preferably obtained as an aluminium panel insulated with Teflon. Another important parameter is the ratio between the volume of the chamber and the volume of the electrode. The electrode is in fact sized so as to guarantee treatment of the amount of granules that can be treated in the volume of the chamber. In the case in point, the ratio between the volume of the chamber and the volume of the electrode is 500:1.

One or more, preferably a pair of, gas-supply ports are provided on the top wall of the chamber 2, as represented in Figure 3. The one or more ports 30 are in fluid communication with the supply unit/cylinder 7B for dispensing reaction gases into the volume V.

With reference to Figures 2-5, in a preferred embodiment of the invention the treatment cell 2 has an at least partially cylindrical shape, and the electrode 26 is set in a position substantially parallel to a generatrix of the aforesaid cylindrical shape. Both the position of the electrode 26 and the shape of the treatment volume are clearly visible in the view of Figure 5,: the electrode is set on a top plane wall 32 of the treatment volume V, which is delimited by a pair of plane side walls 34, 36 and by a bottom cradle-like wall 38, having a circular cylindrical shape and radiused to the walls 34, 36. Set within the treatment volume V is a stirrer device 40 configured for stirring the granular polymer material that, in use, is present within the treatment cell. The stirrer device 40 is of the rotary type (preferably obtained as helical curved profile mounted on spokes 40R) and is rotatable about an axis X40 parallel to a generatrix of the wall 38, and in particular coinciding with a geometrical axis of the cylindrical shape of the latter. Driving in rotation of the stirrer device 40 is obtained by an electric motor M40 that transmits the motion to a motor-reducer R40 (preferably of the screw type) the output shaft of which is connected to the stirrer device 40 by means of a joint J40.

The treatment cell 2 is moreover mounted oscillating about a horizontal axis Y2, transverse to the axis X40. The movement of oscillation can be driven by means of a rope or belt transmission designated by the reference B2.

In general, the following geometrical relations may be noted:
i) the axis X40 of the treatment cell 2 is set aligned to the main direction of development of the electrode 26, and both the axis and the main direction extend along what is a longitudinal direction for the treatment cell 2;
ii) the axis of oscillation Y2 is transverse with respect to the axis X40 and to the main direction of development of the electrode 26; and
iii) the secondary direction of development of the electrode 26 is likewise transverse to the axis X40 and - as has been said - is transverse to the main direction of development.

The treatment cell includes a front wall 42 that can be closed on an inlet mouth of the treatment volume V, which provides both a loading mouth and an unloading mouth of the cell 2. The wall 42 can be set in motion about an axis Z42 by means of an actuator unit 44.

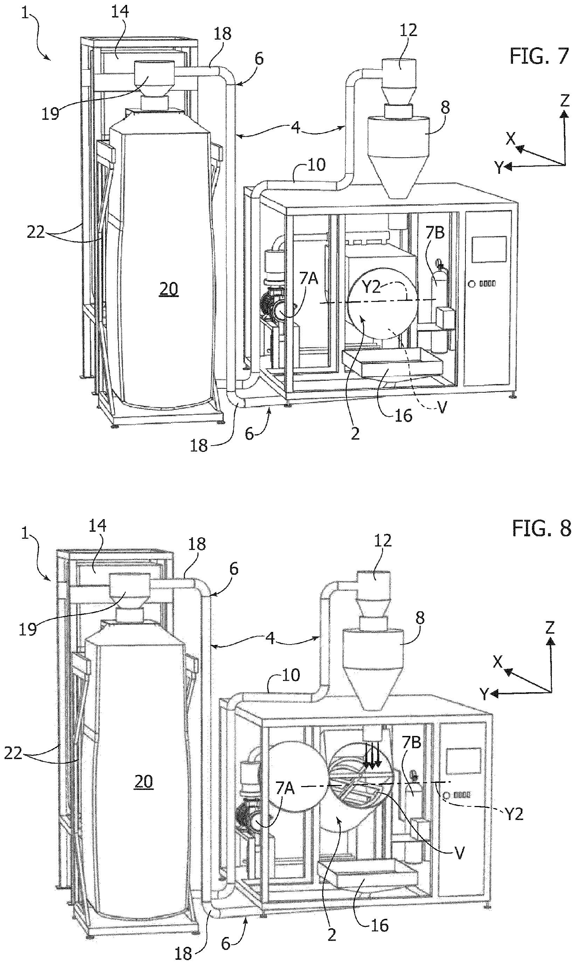

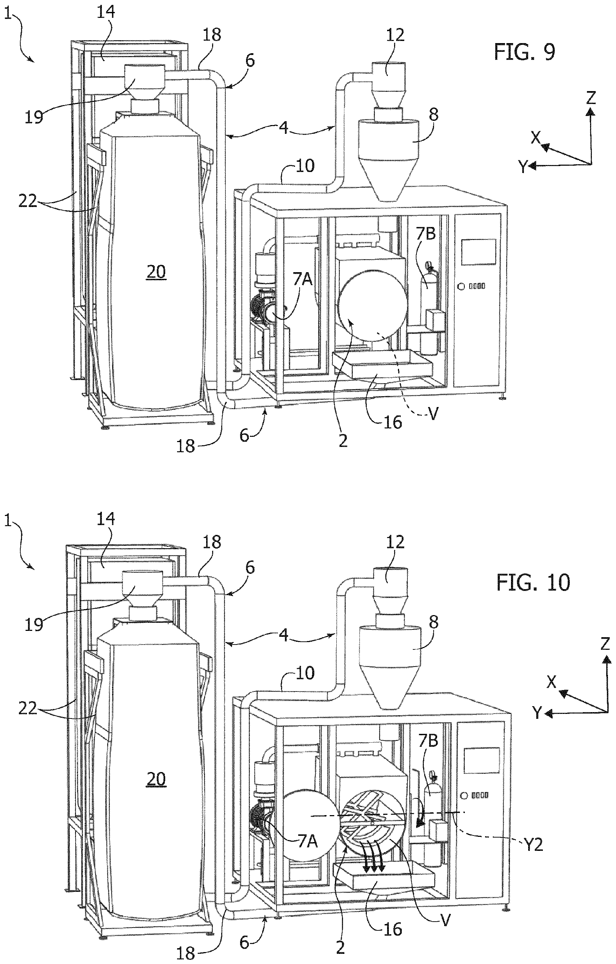

In this regard, the oscillatory movement about the axis Y2 gives rise to three distinct operating positions:
- a loading position, where the inlet mouth of the treatment volume is oriented towards the loading hopper; in the figures (and in particular in Figure 8) this corresponds to a treatment cell in an upward-pitching position; in this position, the wall 42 is open;
- a treatment position, where the treatment cell is kept in a substantially horizontal position (see in particular Figure 9); and
- an unloading position, where the inlet mouth of the treatment volume V is oriented towards the collection tank 16 for the treated polymer material, which for this purpose is set at the foot of the treatment cell; in the figures (and in particular in Figure 10) this corresponds to a treatment cell in a downward-pitching position; in this position, the wall 42 is open.

Operation of the machine 1 is described hereinafter.

Within the treatment cell 2, in the treatment volume V, treatment of a granular polymer material, for example polyethylene, is carried out, with the combined action of vacuum and ionized gases. Ionization of the gases introduced into the treatment volume through the gas-supply unit and the electrode 26 enables modification of the surface of the granules of polymer material, in particular of the surface tension thereof.

The treatment cycle is illustrated schematically in Figures 7 to 10. In Figure 7, the loading hopper 8 is filled with a pre-set amount of granular polymer material to be treated. Dispensing may be conveniently optimized by means of level sensors arranged on the hopper 8. Supply occurs by drawing in the material from the tank 14 by means of the supply device 12 (hence by suction), and by sending it through the duct 10.

At the same time (Figure 8), the treatment cell 2 is opened via rotation of the wall 42 and exposure of the inlet mouth of the volume V, after which the cell 2 is rotated into the loading position. With the inlet mouth of the volume V exposed towards the hopper 8, the bottom of the latter is opened, and the granular polymer material to be treated collected therein migrates into the treatment volume V.

After filling of the treatment volume V, the wall 42 is closed and the treatment volume is isolated.

The cell 2 is rotated into a horizontal (treatment) position and, after prior setting-up of the vacuum within the treatment volume through the negative-pressure source (the operating pressures are in the region of 20 Pa), the plasma treatment starts (Figure 9). The plasma is generated via the electrode 26, which is supplied - according to the material and the treatment - at low frequency (NF) or at high frequency. The latter type of supply may lead to operation in non-thermal (or non-equilibrium) plasma conditions, for example in a discharge regime that is close to, or is superimposed on, the corona-discharge regime. The one or more gases introduced into the chamber through the ports 30 are ionized by the electric field generated in the neighbourhood of the electrode 26, interacting with the surface of the granules of material. The process gases are dispensed via an electronic flow meter, associated to which is a closing valve, which is driven into the closing condition once the desired amount has been dispensed.

The above gases may include, for example:
oxygen - O₂
argon - Ar
nitrogen - N₂
tetrafluoromethane - CF₄
hydrogen - H₂ (which can be used only if the machine 1 is equipped with a system for protection against explosions); and
ethylene - C₂H₄ (which can be used only if the machine 1 is equipped with a system for protection against explosions).

The first four gases can be used in a polyvalent way; i.e., they are functional for scavenging of the treatment volume V at the end of the operating cycle, for activation of the treatment, and for oxidation of the surface of the granules of polymer material to modify their surface tension.

By way of example, a treatment that can be carried out by means of the machine 1 includes the following parameters:
i) supply voltage of the electrode 26: from 600 V to 800 V of maximum amplitude, with an average voltage value comprised between 680 V and 720 V;
ii) power supplied to the electrode: from 600 W to 1500 W;
iii) duration of the treatment (time of supply of the electrode 26): from 120 s to 1200 s;
iv) mass of granular polymer material: from 20 kg to 50 kg, with a grain size comprised between 200 µm and 500 µm.

It should moreover be borne in mind that the geometry of the stirrer device 40 is obtained so as to entrain part of the granules of material undergoing treatment towards the top of the volume V so as to cause subsequent falling thereof by gravity, which favours mixing. An example of geometry of this type is that of a screw stirrer comprising a helical blade with peripheral rims, the latter being configured for raising the granular material. The turns of the helical blade are carried by radial spokes connected to the hub of the stirrer 40, as may be seen in the figures. The stirrer device 40 rotates at a rate of between 5 and 10 r.p.m. The direction of rotation is reversed preferably every 180 seconds.

This treatment cleans and activates the surface of the granules of polymer material, oxidizing it, and brings the values of surface tension thereof to levels that are extremely favourable for adhesion of further non-polar materials (such as the polyurethane foam) or paints. Thanks to the treatment, adhesion improves without any need for interposition of primers or adhesives. In this regard, the aspect ratio of the electrode 26 (with the presence of a main direction of development) and the arrangement thereof in the treatment cell 2 ensure an optimal distribution of the plasma within the treatment volume V, to the advantage of uniformity of treatment of the granular material.

At the end of the treatment, the atmospheric pressure is restored in the treatment volume V after prior switching-off of the electrode 26, and the volume V is scavenged from the process gases. For this purpose, it is possible to use nitrogen gas N₂ as single process and scavenging gas. The wall 42 is then opened again to expose the inlet mouth of the volume V.

The cell 2 is then rotated into an unloading position with the inlet mouth exposed towards the collection tank 16, which hence receives the activated granular polymer material that has just undergone treatment.

Simultaneously, the movement device 19 is screwed (again, preferably a device driven by an electric motor that can be controlled by means of level sensors in the tank 16) for conveying the granular polymer material unloaded into the tank 16 towards the collection bag 20.

The cycle can then be repeated simply by bringing the treatment cell 2 back into a loading position: the loading hopper 8 has in the mean time been filled again with granular polymer material to be treated, ready to be transferred into the treatment volume V.

Ensuring the treatment parameters i) to iv) listed above, the machine 1 hence in general makes it possible to implement in a cyclic way (thanks to the possibility of unloading the treated material and reloading material still to be treated) a method for treatment of granular polymer material comprising the steps of:
- providing a pre-set amount of granular polymer material in the treatment volume (V);
- setting up vacuum conditions in the treatment volume V, preferably by setting up a pressure of between 40 and 90 Pa, more preferably between 40 and 60 Pa, and even more preferably equal to 50 Pa.

- supplying the electrode 26 for generating a plasma within the treatment volume V; and
- stirring the granular polymer material by means of a stirrer device 40.

Thanks to the machine 1 according to the invention, it is possible to treat a granular polymer material without modifying the macroscopic state thereof (the resulting product remains a granular polymer material), but intervening only on the properties of surface adhesion. Consequently, what the machine 1 yields as processing product is an "activated" granular polymer material that can be handled as a conventional granular polymer material, i.e., that can be used as raw material in all the conventional moulding processes without any modification whatsoever to the process itself. It is hence possible, as regards the sector of production of isothermic containers for foodstuff products, to obtain the polypropylene containers with the same process of rotational moulding as the one already used for known containers, but obtaining a semifinished product that does not require any further adaptations for preventing subsequent separation of the filling layer of polyurethane foam. With the activated polyethylene obtained by treatment within the machine 1 it is possible to proceed directly to foaming of the semifinished polyethylene product with the guarantee of a high surface adhesion between the layer of foam and the polypropylene walls. In addition, given the same areas of the surfaces facing the gap that separates the outer and inner walls of the isothermic container (which are the surfaces exposed to foaming), also the surfaces facing outwards have the same properties of surface adhesion: this implies that they are ready for painting without requiring application of primers or the like. The polymer material treated with the machine 1 finds wide use also in the sector of furniture, and in particular in the production of foamed items of furniture. The advantages are the ones mentioned in the above paragraphs: the foam that is injected within the shell of the item adheres to the walls of polymer material without any need for adhesives or primers, and a possible outer paint likewise adheres without any need for further processing operations.

## Claims

1. A machine (1) for plasma treatment of granular polymer material, in particular polyethylene, comprising:
- a treatment cell (2), which delimits a treatment volume (V) for a granular polymer material, ;
- a negative-pressure source (19) in fluid communication (SP) with the treatment volume (V);
- a gas-supply unit (7B) configured for introducing (30) one or more treatment gases for the granular polymer material into said treatment volume (V); and
- an electrode (26) for generation of plasma set inside the treatment cell (2),
wherein:
- said electrode (26) has an elongated shape with a first dimension (D26) oriented in a main direction of development (X) and a second dimension (d26) oriented in a secondary direction of development (Y);
the machine (1) being **characterized in that** said treatment cell (2) comprises a stirrer device (40) configured for stirring the granular polymer material that, in use, is present within the treatment cell (2), and
**in that** the ratio between said first dimension (D26) and said second dimension (d26) is comprised between 20:1 and 15:1.

2. The machine (1) according to Claim 1, wherein said treatment cell (2) has at least in part a cylindrical shape (38), and said electrode (26) is set in a position substantially parallel to a generatrix of said cylindrical shape (38).

3. The machine (1) according to Claim 2, wherein said main direction of development (X) is parallel to a generatrix of said cylindrical shape, whereas said secondary direction of development (Y) is transverse with respect to said generatrix.

4. The machine (1) according to any one of the preceding claims, wherein said treatment cell (2) is mounted oscillating about an axis (Y2) parallel to said secondary direction of development (Y).

5. The machine (1) according to any one of the preceding claims, including a dispenser unit (4) for supply of a pre-set amount of granular polymer material to said treatment cell (2), said dispenser unit (4) including a loading hopper (18) set above said treatment cell (2).

6. The machine (1) according to Claim 5, wherein said treatment cell (2) includes a front wall (42) that can be closed on an inlet of the treatment volume (V), said treatment cell (2) oscillating about said axis (Y2) parallel to said secondary direction of development (Y) from one position to another of the following positions:
- a loading position, where the inlet mouth of the treatment volume (V) is oriented towards said loading hopper (8);
- a treatment position, where the treatment cell (2) is kept in a substantially horizontal position; and
- an unloading position, where the inlet of the treatment volume (V) is oriented towards a collection tank (16) for the treated polymer material, said collection tank (16) being set at the foot of said treatment cell (2).

7. The machine (1) according to Claim 2 or Claim 3, wherein said electrode (26) includes a further secondary direction of development (Z) orthogonal to said main direction of development (X) and to said secondary direction of development (Y), said electrode (26) having a third dimension (h26) oriented in said further secondary direction of development (Z), wherein a ratio between said first dimension (D26) and said third dimension (h26) is comprised between 30:1 and 27:1.

8. The machine (1) according to Claim 1, wherein said stirrer device (40) is a helical blade with peripheral rims, said stirrer device being configured for raising the granular material during rotation and causing subsequent fallout thereof.

9. The machine (1) according to Claim 1, wherein said treatment cell (2) includes one or more suction ports (SP) in fluid communication with said negative-pressure source.

10. A method (1) for the treatment of granular polymer material by means of a machine (1) according to any one of the preceding claims, comprising:
- providing a predetermined amount of granular polymer material in the treatment volume (V);
- setting up vacuum conditions in the treatment volume (V);
- introducing (30) one or more treatment gases for the granular polymer material into said treatment volume by means of said gas-supply unit (7B),
- supplying said electrode (26) for generating a plasma within the treatment volume; and
- stirring the granular polymer material by means of a stirrer device (40),
wherein supplying said electrode comprises supplying it with a supply voltage comprised between 600 V and 800 V of maximum amplitude, with an average value of voltage comprised between 680 V and 720 V, and supplying said electrode with a supply power comprised between 600 W and 1500 W, and
wherein said predetermined amount of granular polymer material is comprised between 20 kg and 50 kg, and has a grain size comprised between 200 µm and 500 µm.

11. The method according to Claim 10, wherein the step of supplying said electrode (26) has a duration comprised between 120 s and 1200 s.

12. The method according to Claim 10 or Claim 11, wherein said stirrer device turns at a rate comprised between 5 r.p.m. and 10 r.p.m., and wherein the direction of rotation is reversed preferably every 180 seconds.

## Patentansprüche

1. Vorrichtung (1) zur Plasmabehandlung von körnigem Polymermaterial, insbesondere Polyethylen, umfassend:
- eine Behandlungszelle (2), die ein Behandlungsvolumen (V) für ein körniges Polymermaterial begrenzt;
- eine Unterdruckquelle (19), die mit dem Behandlungsvolumen (V) in Fluidverbindung (SP) steht;
- eine Gasversorgungseinheit (7B), die dazu ausgelegt ist, dem Behandlungsvolumen (V) einen oder mehrere Behandlungsgase für das körnige Polymermaterial zuzuführen (30); und
- eine innerhalb der Behandlungszelle (2) angeordnete Elektrode (26) zur Erzeugung von Plasma,
wobei:
- die Elektrode (26) eine längliche Form mit einer sich in eine Haupterstreckungsrichtung (X) orientierenden ersten Abmessung (D26) und einer sich in eine zweite Erstreckungsrichtung (Y) orientierenden zweiten Abmessung (d26) aufweist;
wobei die Vorrichtung (1) **dadurch gekennzeichnet ist, dass** die Behandlungszelle (2) eine Rühreinrichtung (40) aufweist, die dazu ausgelegt ist, während der Verwendung der Vorrichtung innerhalb der Behandlungszelle (2) vorhandenes körniges Polymermaterial zu rühren, und dass das Verhältnis zwischen der ersten Abmessung (D26) und der zweiten Abmessung (d26) zwischen 20:1 und 15:1 liegt.

2. Vorrichtung (1) nach Anspruch 1, wobei die Behandlungszelle (2) zumindest teilweise eine zylindrische Form (38) aufweist, und wobei die Elektrode (26) in einer Position im Wesentlichen parallel zu einer Mantellinie der zylindrischen Form (38) angeordnet ist.

3. Vorrichtung (1) nach Anspruch 2, wobei sich die Haupterstreckungsrichtung (X) parallel zu einer Mantellinie der zylindrischen Form erstreckt, und wobei sich die zweite Erstreckungsrichtung (Y) quer zu dieser Mantellinie erstreckt.

4. Vorrichtung (1) nach einem der vorhergehenden Ansprüche, wobei die Behandlungszelle (2) schwenkbar um eine sich parallel zur zweiten Erstreckungsrichtung (Y) erstreckende Achse (Y2) montiert ist.

5. Vorrichtung (1) nach einem der vorhergehenden Ansprüche, umfassend eine Dispensereinheit (4), die dazu ausgelegt ist, der Behandlungszelle (2) eine vorbestimmte Menge körnigem Polymermaterials zuzuführen, wobei die Dispensereinheit (4) einen oberhalb der Behandlungszelle (2) angeordneten Beschickungstrichter (18) aufweist.

6. Vorrichtung (1) nach Anspruch 5, wobei die Behandlungszelle (2) eine vordere Wand (42) aufweist, mit der einen Einlassöffnung des Behandlungsvolumens (V) verschlossen werden kann, wobei die Behandlungszelle (2) um die sich parallel zu der zweiten Erstreckungsrichtung (Y) erstreckende Achse (Y2) aus einer in eine andere der nachfolgenden Positionen geschwenkt werden kann:
- eine Beladeposition, in der die Einlassöffnung des Behandlungsvolumens (V) zum Beschickungstrichter (8) weist;
- eine Behandlungsposition, in der die Behandlungszelle (2) in einer im Wesentlichen horizontalen Position gehalten ist; und
- eine Entladeposition, in der die Einlassöffnung des Behandlungsvolumens (V) zu einem Sammelbehälter (16) für das behandelte Polymermaterial weist, wobei der Sammelbehälter (16) am Fuße der Behandlungszelle (2) angeordnet ist.

7. Vorrichtung (1) nach Anspruch 2 oder 3, wobei die Elektrode (26) eine weitere zweite Erstreckungsrichtung (Z) orthogonal zu der Haupterstreckungsrichtung (X) und zu der zweiten Erstreckungsrichtung (Y) umfasst, wobei die Elektrode (26) eine sich in die weitere zweite Erstreckungsrichtung (Z) orientierende dritte Abmessung (h26) aufweist, wobei ein Verhältnis zwischen der ersten Abmessung (D26) und der dritten Abmessung (h26) zwischen 30:1 und 27:1 liegt.

8. Vorrichtung (1) nach Anspruch 1, wobei die Rühreinrichtung (40) eine schraubenförmige Schaufel mit Umfangsrändern ist, wobei die Rühreinrichtung dazu ausgelegt ist, dass körnige Material während einer Drehung anzuheben und anschließend fallen zu lassen.

9. Vorrichtung (1) nach Anspruch 1, wobei die Behandlungszelle (2) ein oder mehrere Sauganschlüsse (SP) aufweist, die in Fluidverbindung mit der Unterdruckquelle stehen.

10. Verfahren (1) zur Behandlung körnigen Polymermaterials unter Verwendung einer Vorrichtung (1) nach einem der vorhergehenden Ansprüche, umfassend die Schritte:
- Bereitstellen einer vorbestimmten Menge körnigen Polymermaterials in dem Behandlungsvorlumen (V);
- Erzeugen eines Vakuums innerhalb des Behandlungsvolumens (V);
- Einleiten (30) eines oder mehrerer Behandlungsgase für das körnige Polymermaterial in das Behandlungsvolumen unter Verwendung der Gasversorgungseinheit (7B);
- Versorgung der Elektrode (26) zum Erzeugen eines Plasmas innerhalb des Behandlungsvolumens; und
- Rühren des körnigen Polymermaterials unter Verwendung der Rühreinrichtung (40),
wobei das Versorgen der Elektrode das Versorgen derselben mit einer Versorgungsspannung mit einer maximalen Amplitude zwischen 600V und 800V, wobei ein Durchschnittswert der Spannung zwischen 680V und 720V liegt, und das Versorgen der Elektrode mit einer Versorgungsleistung zwischen 600W und 1500W umfasst, und
wobei die vorbestimmte Menge körnigen Polymermaterials zwischen 20kg und 50kg liegt und die Korngröße des körnigen Polymermaterials zwischen 200µm und 500µm beträgt.

11. Verfahren nach Anspruch 10, wobei der Schritt des Versorgens der Elektrode (26) eine Dauer zwischen 120s und 1200s aufweist.

12. Verfahren nach Anspruch 10 oder 11, wobei die Rühreinrichtung mit einer Drehzahl zwischen 5 und 10 Umdrehungen pro Minute dreht, und wobei die Drehrichtung bevorzugt alle 180s umgekehrt wird.

## Revendications

1. Machine (1) pour le traitement au plasma d'un matériau polymère granulaire, en particulier du polyéthylène, comprenant :
- une cellule de traitement (2), qui délimite un volume de traitement (V) pour un matériau polymère granulaire ;
- une source de pression négative (19) en communication fluidique (SP) avec le volume de traitement (V) ;
- une unité d'alimentation en gaz (7B) configurée pour introduire (30) un ou plusieurs gaz de traitement pour le matériau polymère granulaire dans ledit volume de traitement (V) ; et
- une électrode (26) pour la génération de plasma placée dans la cellule de traitement (2),
dans laquelle :
- ladite électrode (26) a une forme allongée avec une première dimension (D26) orientée dans une direction principale de développement (X) et une deuxième dimension (d26) orientée dans une direction secondaire de développement (Y) ;
la machine (1) étant **caractérisée en ce que** ladite cellule de traitement (2) comprend un dispositif d'agitation (40) configuré pour agiter le matériau polymère granulaire qui, en cours d'utilisation, est présent dans la cellule de traitement (2), et
**en ce que** le rapport entre ladite première dimension (D26) et ladite deuxième dimension (d26) est compris entre 20 : 1 et 15 : 1.

2. Machine (1) selon la revendication 1, dans laquelle ladite cellule de traitement (2) a au moins en partie une forme cylindrique (38), et ladite électrode (26) est placée dans une position essentiellement parallèle à une génératrice de ladite forme cylindrique (38).

3. Machine (1) selon la revendication 2, dans laquelle ladite direction principale de développement (X) est parallèle à une génératrice de ladite forme cylindrique, tandis que ladite direction secondaire de développement (Y) est transversale par rapport à ladite génératrice.

4. Machine (1) selon l'une quelconque des revendications précédentes, dans laquelle ladite cellule de traitement (2) est montée de manière oscillante autour d'un axe (Y2) parallèle à ladite direction secondaire de développement (Y).

5. Machine (1) selon l'une quelconque des revendications précédentes, comportant une unité de distribution (4) pour fournir une quantité préréglée de matériau polymère granulaire à ladite cellule de traitement (2), ladite unité de distribution (4) comportant une trémie de chargement (18) placée au-dessus de ladite cellule de traitement (2).

6. Machine (1) selon la revendication 5, dans laquelle ladite cellule de traitement (2) comporte une paroi avant (42) qui peut être fermée sur une entrée du volume de traitement (V), ladite cellule de traitement (2) oscillant autour dudit axe (Y2) parallèle à ladite direction secondaire de développement (Y) d'une position à une autre des positions suivantes :
- une position de chargement, où l'embouchure d'entrée du volume de traitement (V) est orientée vers ladite trémie de chargement (8) ;
- une position de traitement, où la cellule de traitement (2) est maintenue dans une position essentiellement horizontale ; et
- une position de déchargement, où l'entrée du volume de traitement (V) est orientée vers une cuve de collecte (16) pour le matériau polymère traité, ladite cuve de collecte (16) étant placée au pied de ladite cellule de traitement (2).

7. Machine (1) selon la revendication 2 ou 3, dans laquelle ladite électrode (26) comporte une direction secondaire supplémentaire de développement (Z) orthogonale à ladite direction principale de développement (X) et à ladite direction secondaire de développement (Y), ladite électrode (26) ayant une troisième dimension (h26) orientée dans ladite direction secondaire supplémentaire de développement (Z), où un rapport entre ladite première dimension (D26) et ladite troisième dimension (h26) est compris entre 30 : 1 et 27 : 1.

8. Machine (1) selon la revendication 1, dans laquelle ledit dispositif d'agitation (40) est une lame hélicoïdale avec des rebords périphériques, ledit dispositif d'agitation étant configuré pour soulever le matériau granulaire pendant la rotation et provoquer sa chute ultérieure.

9. Machine (1) selon la revendication 1, dans laquelle ladite cellule de traitement (2) comporte un ou plusieurs orifice(s) d'aspiration (SP) en communication fluidique avec ladite source de pression négative.

10. Procédé (1) de traitement d'un matériau polymère granulaire au moyen d'une machine (1) selon l'une quelconque des revendications précédentes, comprenant le fait :
- de fournir une quantité prédéterminée de matériau polymère granulaire dans le volume de traitement (V) ;
- de créer des conditions de vide dans le volume de traitement (V) ;
- d'introduire (30) un ou plusieurs gaz de traitement pour le matériau polymère granulaire dans ledit volume de traitement au moyen de ladite unité d'alimentation en gaz (7B),
- d'alimenter ladite électrode (26) pour générer un plasma dans le volume de traitement ; et
- d'agiter le matériau polymère granulaire au moyen d'un dispositif d'agitation (40),
dans lequel l'alimentation de ladite électrode comprend le fait de lui fournir une tension d'alimentation comprise entre 600 V et 800 V d'amplitude maximale, avec une valeur moyenne de tension comprise entre 680 V et 720 V, et de fournir à ladite électrode une puissance d'alimentation comprise entre 600 W et 1500 W, et
dans lequel ladite quantité prédéterminée de matériau polymère granulaire est comprise entre 20 kg et 50 kg, et a une dimension de grain comprise entre 200 µm et 500 µm.

11. Procédé selon la revendication 10, dans lequel l'étape d'alimentation de ladite électrode (26) a une durée comprise entre 120 s et 1200 s.

12. Procédé selon la revendication 10 ou 11, dans lequel ledit dispositif d'agitation tourne à une vitesse comprise entre 5 tours par minute et 10 tours par minute, et dans lequel la direction de rotation est inversée de préférence toutes les 180 secondes.
